## Europäisches Patentamt
## European Patent Office
## Office européen des brevets

(19)

(11) Publication number: **0 159 589**
A2

(12) # EUROPEAN PATENT APPLICATION

(21) Application number: 85104001.4

(22) Date of filing: 02.04.85

(51) Int. Cl.⁴: **G 09 G 1/16**, G 01 R 13/20

(30) Priority: 06.04.84 JP 69558/84

(43) Date of publication of application: 30.10.85
Bulletin 85/44

(84) Designated Contracting States: **DE GB NL**

(71) Applicant: **TAKEDA RIKEN KOGYO KABUSHIKIKAISHA,
32-1, Asahi-cho 1-chome, Nerima-Ku Tokyo (JP)**

(72) Inventor: **Nagano, Masao, 5-14, Mochida 2-chome,
Gyoda-shi Saitama (JP)**

(74) Representative: **Blumbach Weser Bergen Kramer
Zwirner Hoffmann Patentanwälte, Radeckestrasse 43,
D-8000 München 60 (DE)**

(54) **Display system for a measuring instrument.**

(57) In a display system which displays measured results from a measuring instrument and auxiliary images on a scanning type display (109), by reading out a graphic memory (106) in synchronism with the scanning of the display, an address signal is generated in synchronism with the scanning of the display and the graphic memory is read out by the address signal. The graphic memory has stored therein, for each word, picture element data of plural picture elements, one-bit brightness control data and one-bit resolution control data. The picture element data read out of the graphic memory is converted into serial picture element data for each plural picture elements. The serial picture element data is applied to a resolution control circuit, from which it is output during scanning of one field in interlaced scanning of the display, and during scanning of the other field, the delivery of the serial picture element data from the resolution control circuit (201) is allowed or inhibited in accordance with the resolution control data. The output serial picture element data from the resolution control circuit and the brightness control data are provided to a brightness modulator (204), from which a signal of a level corresponding to the both data is applied as a display signal to the display.

## DISPLAY SYSTEM FOR A MEASURING INSTRUMENT

### BACKGROUND OF THE INVENTION

The present invention relates to a display system for measuring instruments which displays measured data of a spectrum analyzer or similar measuring instrument as a waveform on a scanning type display device such as a cathode-ray tube display, together with auxiliary or optional display images such as a marker, a scale and a cursor.

With this kind of display system, in the case of displaying a waveform of measured data and a marker for indicating a desired position on the waveform, the marker is displayed at higher brightness than the waveform so as to attract attention. To this end, it is customary in the prior art to use, for each picture element of the display screen, at least a data bit indicating whether to provide a bright-spot display and, in the case of producing the bright-spot display, a data bit indicating the brightness of the spot.

Further, in this kind of display system picture element data to be displayed at each position on the display screen of the display is stored in a graphic memory at an address corresponding to the position on the display screen. The graphic memory is read out in synchronism with scanning of the display screen and the picture data read out of the graphic memory is supplied as a display signal to the display. For displaying a marker at the same brightness as the waveform of measured data, one-bit picture element data for each picture element is enough. For displaying the marker at higher brightness than the waveform display as mentioned above, however, at least two bits are needed for the picture element data of each picture element, and hence the storage capacity of the graphic memory must be increased twice larger than in the case where one-bit picture element data is used for each picture element.

The graphic memory is to store picture element data for each position on the display screen, and hence is large in storage capacity. The storage capacity, if increased twice, will therefore become extremely large.

From the standpoint of reducing the storage capacity of the graphic memory, it has been proposed to apply the same display signal to each two scanning lines on the display screen for providing a display, but this has the defect of a decrease in the resolution of an image being displayed.

## SUMMARY OF THE INVENTION

It is therefore an object of the present invention to provide a display system for measuring instruments which enables brightness control with more levels than in the past, without an appreciable increase of the storage capacity of the graphic memory, and permits a substantial reduction of the storage capacity of the graphic memory in the case of performing brightness control at the same number of levels as in the past.

Another object of the present invention is to provide a display system for measuring instruments which permits a substantial reduction in the storage capacity of the graphic memory without causing an appreciable decrease in resolution.

According to the present invention, an address signal, which indicates the scanning position on the display screen of a scanning type display the display screen of which is subjected to horizontal (line) and vertical (plane) scanning, such as a CRT display, plasma display or liquid crystal display, is generated by an address generator in synchronism with the scanning of the display screen. The graphic memory, which has stored therein, for each word, picture element data of plural picture elements and brightness control data of at least one bit, is read out by the address signal. The picture element data in each word read out of the graphic memory is converted by a parallel-serial converter into serial picture element data for each plural successive picture elements and then supplied to a brightness modulator. The brightness control data in each word thus read out of the graphic memory is controlled, as required, by a brightness timing circuit, to time with the serial picture element data and is then applied to the brightness modulator. The brightness modulator provides, as a display signal, to the scanning type display a signal of a level corresponding to the value of the input serial picture element data for each picture element and the value of the input brightness control data.

As described above, according to the present invention, a plurality of picture element data are used for each word but the number of brightness control data bit therefor is only one in the case of minimum, and accordingly, the same brightness control is effected for the plurality of picture element data, too. For example, let it be assumed that the picture element data has one bit for each picture element and the number of brightness control data is one. When the brightness control data in a word is a "0", a "0" (L logic) and a "1" (H logic) in the plural picture element data in the word are made a level 0 and a level 1, respectively, and when the brightness control data in a word is a "1", a "0" and a "1" in the plural picture element data in the word are made a level 0 and a level 2, respectively. Consequently, letting the number of picture elements per word be represented by n, the total amount of brightness control data is 1/n the amount needed in the case where the brightness control data is provided for each picture element, and the storage capacity of the graphic memory needed is smaller by that. For example, in the case of increasing the brightness of a marker as mentioned previously, if the marker is displayed in a size measuring 10 by 10 bits and the number of picture elements for one word is six, then at least one-half or so of the marker becomes of high brightness irrespective of the position of the marker, facilitating its recognition.

One-bit resolution control data is prestored along with the brightness control data, in addition to the picture element data of plural picture elements, in the graphic memory for each word, and an interlaced scanning type display is used as the scanning type display. From the address generator are also produced a field bit which indicates whether the scanning type display is scanning an odd or even field, and the graphic memory is read out by the address signal from which the field bit has been separated. The picture element data read out of the graphic memory is converted by the parallel-serial converter into serial picture element data, which is applied to a resolution control circuit. To the resolution control circuit are supplied with the field bit from the address generator and the resolution control data from the graphic memory as well. For one value of the field bit, the resolution control circuit outputs all the input serial picture element data and, for the other value of the field bit, the resolution control circuit effects control of sending out and cutting off of the serial picture element data in accordance with the resolution control data. The output picture element data from the resolution control circuit is rendered by the brightness modulator into a signal of a level corresponding to the picture element data, and the signal is provided as a display signal to the scanning type display.

In this case, parts of the waveform thus displayed which extend in parallel to the horizontal scanning lines are displayed as thin lines because the picture element data is cut off based on the resolution control data, whereas, for parts crossing the horizontal scanning lines, the picture element data is provided from the resolution control circuit in any fields; as a result, the line of the waveform is displayed clearly, thus providing, in appearance, for enhanced resolution in the display as a whole. Since the resolution control data is only one bit for each word, resolution can be improved by slightly increasing the storage capacity of the graphic memory as compared with the storage capacity needed in the case for providing the same display signal to each two adjacent scanning lines. Further, deterioration of resolution is relatively small and the storage capacity of the graphic memory can be substantially reduced as compared with the case of storing picture element data for each picture element.

It is also possible to arrange such that picture element data of plural picture elements, one-bit brightness control data and one-bit resolution control data are stored in each word in the graphic memory, and the output picture element data from the aforesaid resolution control circuit and the brightness control data from the graphic memory are supplied to the brightness modulator to produce therefrom, as a display signal, a signal of a level corresponding to the both data, which display signal is supplied to the scanning type display.

BRIEF DESCRIPTION OF THE DRAWINGS

Fig. 1 is a block diagram illustrating a conventional display system for a measuring instrument;

Fig. 2 is a block diagram showing a specific operative example of a read address generator used in Fig. 1;

Fig. 3 is a block diagram illustrating an embodiment of the display system of the present invention;

Figs. 4A through 4E are timing charts explanatory of the operation of the embodiment shown in Fig. 3;

Fig. 5 is a logic circuit diagram illustrating a specific operative example of a resolution control circuit utilized in Fig. 3;

Fig. 6 is a diagram showing an example of a display provided on the display screen of a scanning type display 109; and

Fig. 7 is a connection diagram illustrating specific operative examples of a brightness timing circuit 202 and a brightness modulator 204 employed in Fig. 3.

DESCRIPTION OF PREFERRED EMBODIMENTS

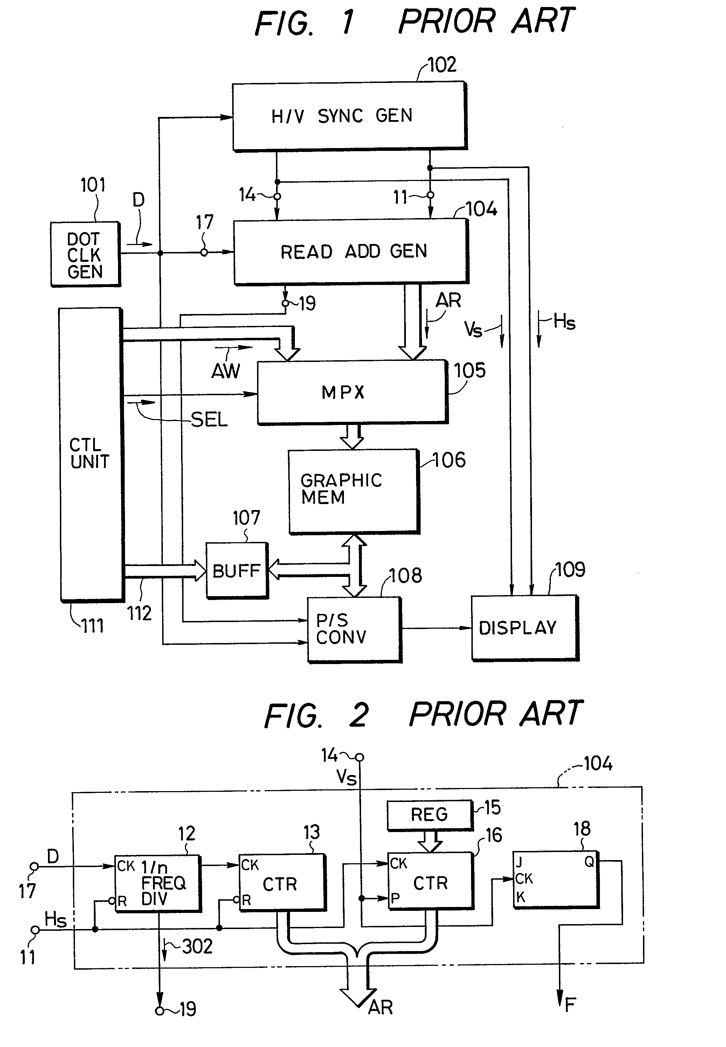

To facilitate a better understanding of the present invention, a description will be given first, with reference to Fig. 1, of a conventional display system for measuring instruments. A dot clock D from a dot clock generator 101 is applied to a horizontal/vertical synchronizing signal generator 102, from which are produced a horizontal synchronizing signal Hs and a vertical synchronizing signal Vs. The horizontal and vertical synchronizing signals Hs and Vs are provided to a scanning type display 109 to control horizontal and vertical scanning of its display screen. At the same time, the synchronizing signals Hs and Vs and the dot clock D are supplied to a read address generator 104 to yield therefrom a read address signal AR indicating the position of scanning on the display screen of the scanning type display 109.

The read address generator 104 is arranged, for example, as shown in Fig. 2, in which a frequency divider 12 and a counter 13 are reset by the horizontal synchronizing signal Hs from a terminal 11 and data indicating the number of scanning lines of one field stored in a register 15 is preset in a counter 16 by the vertical synchronizing signal Vs from a terminal 14. The dot clock D from a terminal 17 is frequency divided by the frequency divider 12 down to 1/n, and the frequency-divided output is counted by the counter 13. The counter 16 counts down the horizontal synchronizing signal Hs applied to the terminal 11. The count values of the counters 13 and 16 are output as the read address signal AR. The frequency divider 12 provides to the terminal 19 a frequency-divided output slightly leading in phase the frequency-divided output to the counter 13. When the display 109 is an interlaced scanning type one, the vertical synchronizing signal Vs at the terminal 14 is applied to a flip-flop 18, from which a field bit F indicating whether the field being scanned in the display 109 is an odd or even field is generated, together with the read address signal AR. The read address signal AR is provided to a multiplexer 105 in Fig. 1.

To the multiplexer 105 is also supplied a write address signal AW from a control unit 111 which is formed by a microcomputer, and either one of the read address signal AR and the write address signal AW is selectively applied to a graphic memory 106. The multiplexer 105 normally operates in a readout mode and selects the read address signal AR. When the contents of a display are to be changed, the control unit 111 enters a write mode, in which it controls the multiplexer 105 by a select signal SEL to select the write address signal AW and accesses the graphic memory 106 by the write address signal AW to write therein via a data bus 112 and a buffer 107 such picture element data that is composed of plural bits each representing corresponding one picture element, for instance.

A parallel-serial converter 108 can be formed, for instance, by a presettable shift register, and it converts parallel picture element data of n picture elements (corresponding to the 1/n frequency-divided output of the frequency divider 12 in Fig. 2) read out of the graphic memory 106, into serial picture element data, which is applied as a display signal to the display 109 for display thereon.

With the above conventional display system, the graphic memory 106 needs to have a storage capacity corresponding to the number of picture elements of one picture frame. Accordingly, a memory of a relatively large storage capacity is required as the graphic memory 106. The storage capacity of the graphic memory 106 can be reduced, for example, by using an interlaced scanning type display as the display 109 and providing a display with the same picture data for both odd and even fields, but this incurs the reduction of resolution. Further, in the case of displaying a marker, along with a measured waveform, and at a higher intensity, a storage capacity of another picture frame is needed therefor.

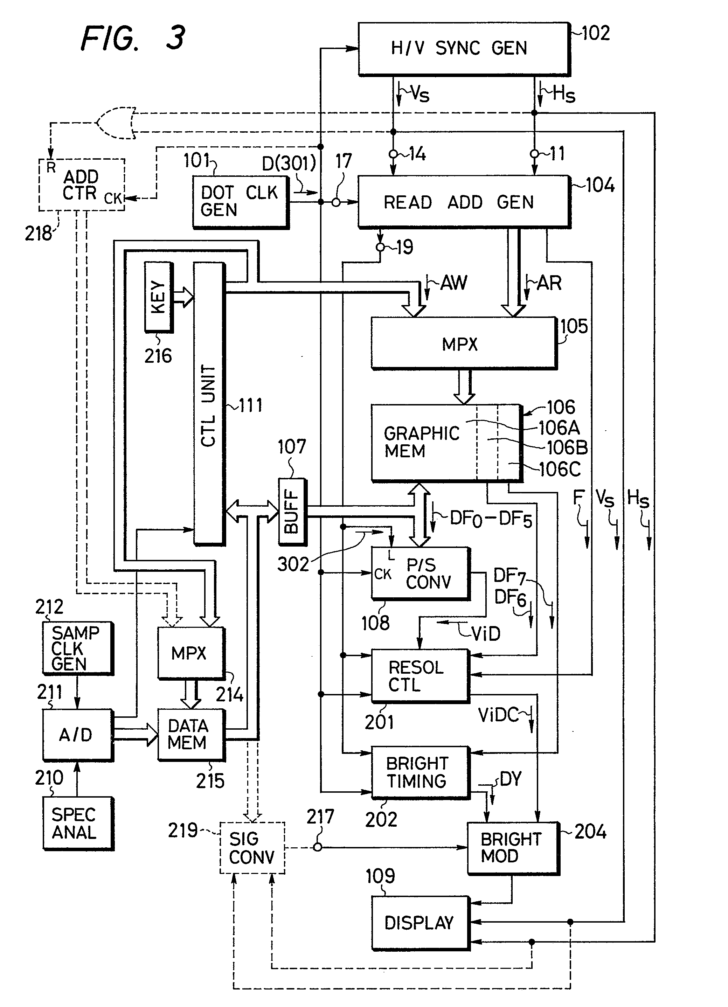

Fig. 3 illustrates an embodiment of the present invention. In Fig. 3 like parts corresponding to those in Fig. 1 are identified by the same reference numerals and no detailed description will be repeated thereon. In this embodiment, each memory word in the graphic memory 106 is divided into an n-bit picture element data storage area 106A for storing picture element data for n successive picture elements, a one-bit resolution control data storage area 106B and a one-bit brightness control data storage area 106C. Accordingly, the graphic memory 106 is preferably a (n+2)-bit word memory. Where the number of scanning lines of the display 109 is 512, the total number of picture elements to be stored in the picture element storage area 106A of the graphic memory 106 is selected to be 256 in terms of the number of scanning lines, and an interlaced scanning type display is used as the display 109. Its odd and even fields are both interpolated by reading out the same graphic memory 106, and the interpolation is controlled every plural picture elements by the resolution control data that is read out from the graphic memory 106. More specifically, picture element data of plural picture elements and resolution control data which are read out of the graphic memory 106 for each word are provided to a resolution control circuit 201, and picture element data available therefrom is controlled in accordance with the resolution control data.

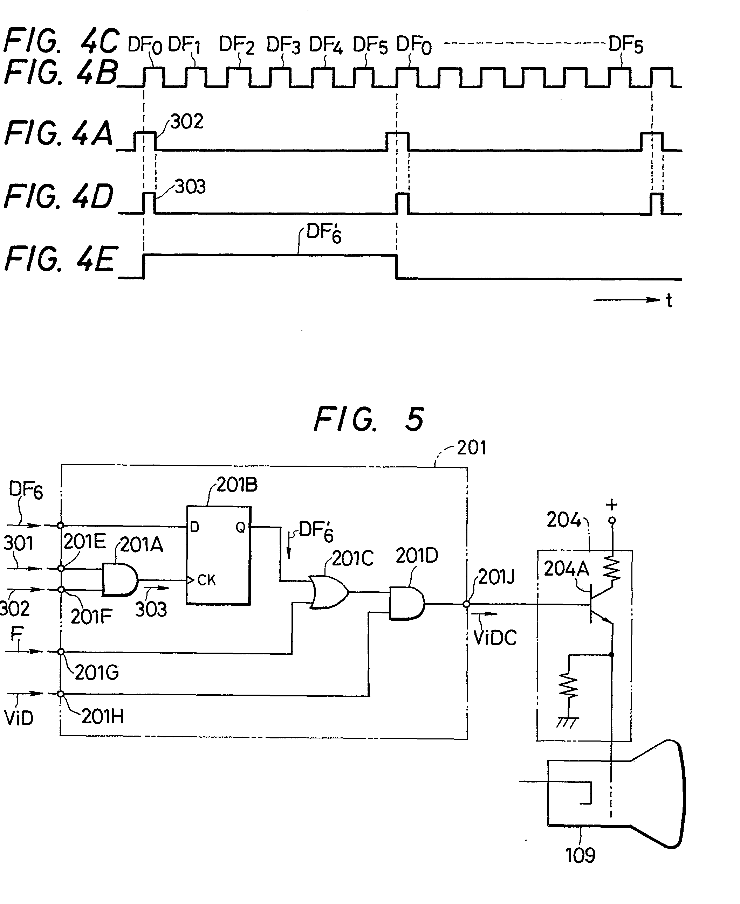

Let it be assumed, in this example, that the graphic memory 106 has stored therein at each address (word) an eight-bit signal which includes picture element data $DF_0$ to $DF_5$ of six bits, each corresponding to one picture element, resolution control data $DF_6$ of one bit and one brightness control data (of one bit in this example). Accordingly, upon each advancement of the read address AR which is provided from the read address generator 104, the picture element data $DF_0$ to $DF_5$ of six bits, the resolution control data $DF_6$ of one bit and the brightness control data $DF_7$ of one bit are read out of each address. The parallel picture element data $DF_0$ to $DF_5$ of six bits are converted into serial picture element data. The parallel-serial converter 108 can be formed by a shift register in practice. The parallel picture element data $DF_0$ to $DF_5$ of six bits, read out of the graphic memory 106, are loaded in respective shift stages of a six-bit shift register by means of a load pulse 302 (obtained from the terminal 17 in Fig. 2) shown in Fig. 4A. Then the shift register is shifted by shift pulses (the dot clock D) 301 shown in Fig. 4B, by which the parallel picture element data $DF_0$ to $DF_5$ are converted into serial picture element data in the order $DF_0$-$DF_1$-$DF_2$-$DF_3$-$DF_4$-$DF_5$. Since the picture element data loaded in the shift register is six-bit, the load pulse shown in Fig. 4B rises up after a six-clock elapsed time, by which parallel six-bit picture element data read out of the graphic memory 106 next is loaded in the parallel-serial converter 108. By the repetition of this operation, the picture element data stored in the graphic memory 106 is converted into serial picture element data, which is provided as serial picture element data ViD to the resolution control circuit 201.

Fig. 5 illustrates a specific operative example of the arrangement of the resolution control circuit 201. The resolution control circuit 201 can be constituted by an AND gate 201A, a D flip-flop 201B, an OR gate 201C and an AND gate 201D. The AND gate 201A is supplied at one input terminal 201E with the shift pulse 301 (the dot clock D) shown in Fig. 4B and at the other input terminal 201F with the load pulse 302 (Fig. 4A). The output of the AND gate 201A is provided to a clock input terminal CK of the D flip-flop 201B. The D flip-flop 201B is supplied at its data terminal D with the resolution control data $DF_6$ from the graphic memory 106.

The D flip-flop 201B has its output terminal Q connected to one input terminal of the OR gate 201C, the other input terminal of which is supplied from a terminal 201G with the field bit F (which is the output of the flip-flop in Fig. 2) indicating whether the field being scanned in the display 109 is an odd or even field. The field bit F is produced by the read address generator 104, as described previously in connection with Fig. 2, and it assumes, for example, H logic for the odd field and L logic for the even field. The output of the OR gate 201C is applied to one input terminal of the AND gate 201D, the other input terminal of which is supplied from a terminal 201H with the serial picture element data ViD from the parallel-serial converter 108. At the output of the AND gate 201D is obtained serial picture element data ViDC controlled in accordance with the resolution control data $DF_6$. The serial picture element data ViDC is applied to an output terminal 201J, from which it is provided to a control terminal (a base) of a switching element (a transistor) 204A in a brightness modulator 204. The brightness of the display screen of the display 109 is modulated by the output of the brightness modulator 204, displaying the picture element data as an image on the display 109.

With the circuit arrangement shown in Fig. 5, the field bit F which is applied to the input terminal 201G takes H logic during the odd-field scanning and L logic during the even-field scanning, as defined previously. During the odd-field scanning the AND gate 201D is enabled by the field bit F, and consequently, all the serial picture element data ViD is provided to the output terminal 201J.

On the other hand, during the even-field scanning the field bit F takes L logic. As a result of this, the AND gate 201D is not enabled by the field bit F, but instead it is controlled by the output signal of the D flip-flop 201B to open and close. That is, in the even-field scanning, the AND gate 201D is enabled or disabled depending upon the state of the resolution control data $DF_6$, by which it is controlled whether to display the same picture element data every two adjacent scanning lines as required. This control can be achieved for every six picture elements since the resolution control data $DF_6$ is included in each word of the graphic memory 106.

The D flip-flop 201B inputs therein, by the output signal 303 of the AND gate 201A shown in Fig. 4D, the resolution control data $DF_6$ in the area 106B of a word read out of the graphic memory 106 and derives at the output terminal Q resolution control data $DF_6'$ which is synchronized with the rise of the dot clock 301, as shown in Fig. 4D. In other words, the resolution control data $DF_6$ is controlled by the D flip-flop 201B to time with the serial picture element data ViD for the picture element data $DF_0$ to $DF_5$ read out simultaneously with the data $DF_6$. When the timed resolution control data $DF_6'$ takes H logic, the AND gate 201D is enabled to output therethrough the serial picture element data ViDC even during the even-field scanning.

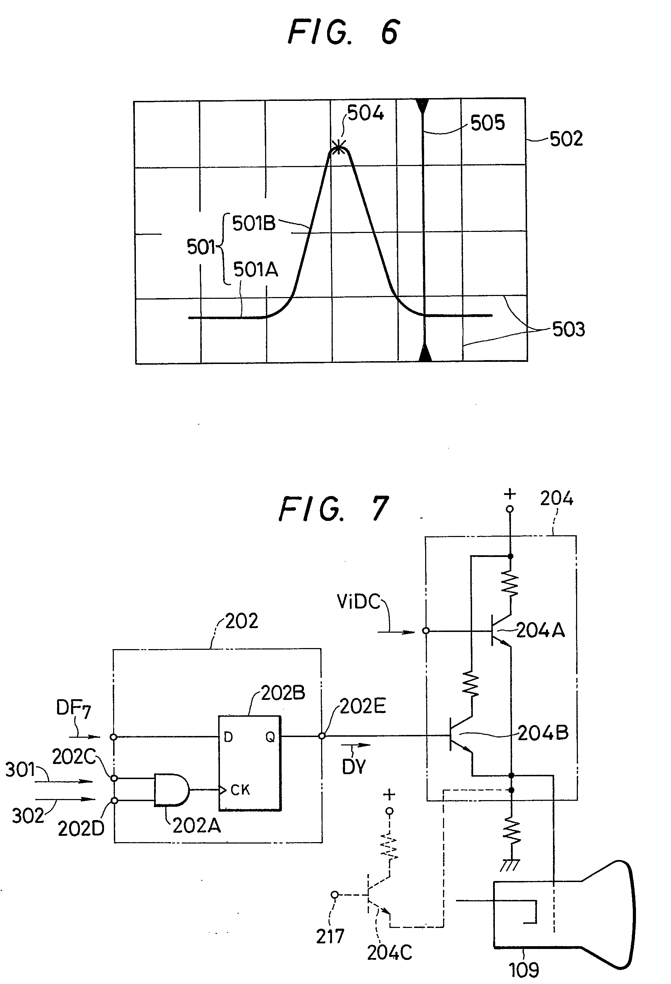

With such an arrangement that makes it possible to control whether to output the serial picture element data ViD during the even-field scanning as described above, when such a waveforms 501 as shown in Fig. 6 is to be displayed on the display screen 502 of the display 109, L logic is prestored as the resolution control data $DF_6$ for a part displaying substantially horizontal line (a line parallel to the scanning line) 501A and the H logic is prestored as the resolution control data $DF_6$ for a part

displaying a line 501B containing a vertical component.

By this, in the part where to display the substantially horizontal line 501A, the picture element data ViDC is generated only during the odd-field scanning to display the line 501A. In this case, the line 501A is displayed based solely on the picture element data ViDC which is produced during the odd-field scanning, the line thus displayed is thin and clear.

In contrast thereto, in the part where to display the line 501B containing vertical components, the picture element data ViDC is provided in both odd and even fields to project images on adjacent scanning lines, thus drawing a continuous line in the vertical direction.

Accordingly, only with the storage capacity of the graphic memory 106 that is only one-half of the storage capacity needed for storing the picture element data of all the scanning lines, plus the storage capacity for the resolution control data, an image can be displayed apparently with good resolution. In this example, since the resolution control data is assigned one bit for six picture elements, the required storage capacity is 7/12 of that needed for storing the picture element data of all scanning lines.

In Fig. 6, a scale 503 is fixedly displayed on the display screen 502 and a marker 504 can be selectively displayed at a desired position on the waveform 501. Similarly, a cursor 505 can also be moved to a desired position for display.

Incidentally, the write in the graphic memory 106 is effected, for example, as follows: As shown in Fig. 3, a measured signal from a measuring instrument (for example, a spectrum analyzer) 210 is applied to an A/D converter 211, wherein it is sampled by a sampling clock of a fixed period from a sampling clock generator 212 and each sample value is converted into, for instance, 9-bit digital data. Upon each conversion, the control unit 111 is interrupted, and it provides an address via a multiplexer 214 to a data memory 215 for addressing it to store therein the digital data from the A/D converter 211. The storage in the data memory 215 is disclosed, for example, in United States Patent No. 4,464,656 (issued on August 7, 1984). Upon completion of the write in the data memory 215 for a series of measured signals, the control unit 111 provides an address via the multiplexer 214 to the data memory 215 to read it out and the control unit 111 inputs therein the data read out of the data memory 214 and then, based on the address therefor and the value of the input data, writes H logic in the graphic memory 106 at the address that corresponds to the position (X, Y coordinates) on the display screen of the display 109 where the data read out of the data memory 215 is to be displayed. Such a write is effected while sequentially reading out data from the data memory 215 at respective addresses. The data thus read out is compared with the immediately read out data, and if the former differs from the latter, then the H logic is written in the resolution control data storage area 106B of the graphic memory 106 at the address corresponding to that data.

Next, a description will be given of brightness control based on the brightness control data $DF_7$ which is read out of the area 106C in the graphic memory 106. As shown in Fig. 3, the brightness control data $DF_7$ read out of the brightness control data area 106C of the graphic memory 106 is provided to a brightness timing circuit 202, wherein it is timed with the picture element data ViD from the parallel-serial converter 108, thereafter being applied to the brightness modulator 204.

Fig. 7 illustrates a specific arrangement of the brightness timing circuit 202. The brightness timing circuit 202 can be formed by an AND gate 202A and a D flip-flop 202B. The dot clock 301, shown in Fig. 4B, is applied to one input terminal 202C of the AND gate 202A and the load pulse 302 is provided to the other input terminal 202D of the AND gate 202A. The D flip-flop 202B is supplied at its data input terminal D with the brightness control data $DF_7$ and has its output terminal Q connected to an output terminal 202E of the brightness timing circuit 202, and the output terminal 202E is connected to a control terminal (a base) of a brightness modulation switching element (a transistor) 204B provided in the brightness modulator 204.

In the arrangement depicted in Fig. 7, the brightness control data $DF_7$ is read out of the storage area 106C at the same time as the picture element data $DF_0$ to $DF_5$ are read out of the graphic memory 106. By the dot clock 301 and the load pulse 302, an output similar to the pulse 303 shown in Fig. 4D is obtained at the output of the AND gate 202A, and by the rise of this output, the brightness control data $DF_7$ is written into the D flip-flop 202B. In other words, the brightness control data $DF_7$ is timed with the serial picture element data ViD of the picture element data $DF_0$ to $DF_5$ read out at the same time as the data $DF_7$. Consequently, while the serial picture element data ViDC is being applied to a switching element 204A of the brightness modulator 204, the D flip-flop 202B provides at the output terminal Q a brightness control signal DY of the same logic as that of the brightness control data $DF_7$, and the brightness control signal DY is applied to the control terminal (the base) of the brightness modulation switching element (the transistor) 204B.

For example, when the brightness control data $DF_7$ is of H logic, the D flip-flop 202B produces an H-logic signal at its output terminal Q, which signal is applied to the control terminal of the brightness modulation switching element 204B. As a result of this, the switching element 204B is controlled to be in the ON state while the brightness control signal DY is at H logic, and an ON current through the switching element 204B is superposed on a current through the switching element 204A which is controlled by the serial picture element data ViDC, thereby increasing the brightness at the picture elements to which the brightness control data is applied in this example. Consequently, the brightness of a luminous portion of the display screen of the display 109 at this time is higher than in the case where only the picture element data ViDC is applied.

On the other hand, when the brightness control data $DF_7$ is of L logic, the D flip-flop 202B yields L logic at the output terminal Q. At this time, the brightness modulation switching element 204B is held in the OFF state and the brightness of the luminous portion of the display screen of the display 109 is dependent upon the picture element data ViDC alone; namely, the brightness is lower than that of the portion where the brightness control data $DF_7$ is of the H logic.

As described above, each picture element data for plural (six in this example) picture elements is stored together with the brightness control data $DF_7$, and the brightness control data $DF_7$ is read out along with the picture element data for the plural picture elements for brightness modulation, by which the brightness of bright spots on the screen can be varied in two stages in the embodiment depicted in Fig. 7. In consequence, a desired portion of a display image can be made bright or dark. For instance, various regions on the screen can each be displayed in distinction from the others in terms of brightness. Hence, apparent resolution of a display image can be improved.

For example, in the case of displaying the marker 504 at a higher brightness than the waveform 501 in Fig. 6, the brightness control data $DF_7$ corresponding to the picture element data of the marker 504 is stored as H logic in the graphic memory 106 at the address (word) where the abovesaid picture element data is stored. The marker 504 is displayed in a size of 10 x 10 bits, for instance. Accordingly, in the above example the brightness control data $DF_7$ for the marker 504 is made H-logic for two words successive in the horizontal scanning direction. The marker 504 is displayed in the following manner: When the operator actuates, for example, a marker key 216 (Fig. 3) to enter necessary data into the control unit 111, the data is input as an address of the data memory 215 (Fig. 3). Based on the marker position input, the control unit 111 reads out data from the data memory 215, obtains the position on the display screen 502 of the display 109 where the data is to be displayed, and writes in the graphic memory 106 picture element data for displaying the marker 504 at that position. In general, the measured data value at the position specified by the marker 504 is displayed on a digital display (not shown) separately provided. It is apparent that easy recognition of a marker location on the display screen will greatly help the operator perform measuring procedures. Therefore, the marker 504 needs only to be easily located on the screen 502 and it is not critical which picture element the marker starts at.

Accordingly, the function of the marker 504 can sufficiently be obtained by using one brightness control data every six picture element, as described above. Conventionally, the brightness control data is used for each picture element, so a storage capacity of one picture frame is needed for the brightness control data. In contrast thereto, in the above example the storage capacity for the brightness control data is only one-sixth of that needed in the past. In the case of displaying the cursor 505 on the display screen 502, the brightness control data $DF_7$ at the address (word) of the graphic memory 106 where the picture element data for displaying the cursor 505 is stored, is made H-logic so that the cursor 505 can easily be distinguished from the fixed scale 503. The picture element data for displaying the scale 503 is also stored in the graphic memory 106 at the corresponding addresses.

While in the above the AND gate 201A and the D flip-flop 201B are used in Fig. 5 and the brightness timing circuit 202 is used in Fig. 5 so that the resolution control data $DF_6$ and the brightness control data $DF_7$ are timed with the serial picture element data ViD, it is also possible to omit them and to supply the resolution control data $DF_6$ directly to the OR gate 201C in Fig. 5 and the brightness control data $DF_7$ directly to the switching element 204B in Fig. 7. In these cases, it is also possible to adopt such an arrangement that the addresses for writing the resolution control data $DF_6$ and the brightness control data $DF_7$ into the graphic memory 106 are shifted from those for the corresponding picture element data by address number corresponding to a time lag between these control data and the serial picture element data ViD.

In the case of employing an 8-bit microcomputer as the control unit 111 and an 8-bit word memory as the graphic memory 106, when the picture element data, the resolution control data $DF_6$ and the brightness control data $DF_7$ are assigned six bits, one bit and one bit, respectively, as in the above example, the data to be handled at a time is 8-bit and hence is easy to process. Further, when employing such an 8-bit data configuration, if a 16-bit microcomputer and a 16-bit word memory are used as the control unit 111 and the graphic memory 106, then two sets of 8-bit data each set having the 6-bit picture element data, the one-bit resolution control data and the one-bit brightness control data, are stored at each address (i.e. 16-bit word) and the data may be read out 8 bits at a time.

Although the embodiment shown in Fig. 3 uses the resolution control data $DF_6$ and the brightness control data $DF_7$, either one of them can be omitted. That is, when the brightness control data $DF_7$ is not used, the brightness timing circuit 202 is omitted in Fig. 3 and the brightness modulator 204 is arranged as shown in Fig. 5. When the resolution control data $DF_6$ is omitted, it is necessary only to leave out the resolution control circuit 201 and to apply the serial picture element data ViD from the parallel-serial converter 108 directly to the brightness modulator 204.

For instance, where the output measurement data from the measuring instrument 210 (Fig. 3) undergoes relatively rapid variations but the processing speed of the control unit 111 is relatively low, a measured signal is provided as a waveform display signal via a terminal 217 to the brightness modulator 204 and data for such auxiliary display images as the scale 503, the marker 504 and the cursor 505 are stored as the picture element data $DF_0$ to $DF_5$ in the graphic memory 106 and, further, at least the brightness control data $DF_7$ and, if necessary, the resolution control data $DF_6$ are stored corresponding to them. The measured signal which is provided to the terminal 217 is such as follows: As indicated by broken lines in Fig. 3, an address generating counter 218 is reset by the horizontal and vertical synchronizing signals H and V, and the dot clock D is counted by the address generating counter 218. The count value of the counter 218 is applied via the multiplexer 214 to the data memory 214 to read it out, and the data read out of the data memory 215 is converted by a signal converting part 219 into a display signal, which is provided to the terminal 217. The display signal converting part 219 is formed by a comparator 103 and a video signal generator 104 shown in Fig. 1 of the aforementioned United States Patent No. 4,464,656, or a comparator 507, a down counter 508 and the arrangement succeeding them in Fig. 5 of the same patent. The waveform display signal thus obtained from the terminal 217 of the display signal converting part 219 is provided to the control terminal of a switching element 204C in the brightness modulator 204, for example, as indicated by broken lines in Fig. 7, and the outputs of the switching elements 204A, 204B and 204C are added together and then the added output is supplied to the display 109 for brightness modulation.

While in the above the brightness control data is described as to be one-bit, it is also possible to assign a plurality of bits to this data so that brightness control is effected at a plurality of stages. The reduction of the storage capacity of the graphic memory 106, as described above, leads to the reduction in size of the graphic memory 106 itself, and hence is advantageous in incorporating the display system for a measuring instrument into measuring apparatus.

It will be apparent that many modifications and variations may be effected without departing from the scope of the novel concepts of the present invention.

- 1 -          0159589

WHAT IS CLAIMED IS:

1. A display system for displaying the results of measurement by a measuring instrument and/or auxiliary images on a scanning type display (109), in which an address signal indicative of the position of scanning on the display screen of the display is generated by an address generator (104) in synchronism with the scanning; a graphic memory (106) is read out by the address signal from the address generator; the graphic memory has stored therein, for each word, picture element data of plural picture elements; the picture element data simultaneously read out of the graphic memory are converted by a parallel-serial converter (108) into serial picture element data for each plural picture elements; the serial picture element data is supplied to a brightness modulator (204); the brightness modulator applies, as a display signal, to the display a signal of a level corresponding to the value of the input picture element data for each picture element; characterized in that:

the graphic memory (106) has stored therein, in each word, at least one-bit brightness control data; and

the brightness control data read out of the graphic memory is supplied to the brightness modulator (204), together with the serial picture element data for picture element data simultaneously read out of the graphic memory, and the brightness modulator outputs, as the display signal, a signal of a level corresponding to the both serial picture element data and brightness control data.

2. A display system according to claim 1, including a brightness timing circuit for supplying the read-out brightness control data to the brightness modulator at the same timing as the serial picture element data.

3. A display system according to claim 2, wherein the brightness modulator comprises a circuit for generating a signal of a level corresponding to the magnitude of each picture element data of the serial picture element data, a circuit for generating a signal of a level corresponding to the brightness control data and a circuit for adding together the outputs of the both circuits to yield the added output as the display signal.

4. A display system according to claim 2, wherein each word of the graphic memory consists of eight bits, in which at least six bits are assigned to picture element data one bit for each picture element and one bit is assigned to the brightness control data.

5. A display system according to claim 2, wherein the graphic memory has stored therein, as the picture element data, data indicating the auxiliary display images; and wherein a measured signal from the measuring instrument, which is to be displayed as a waveform, is provided to the brightness modulator; and the brightness modulator provides, as display signals, to the display a signal of a level given on the basis of the input measured signal, the serial picture element data and the brightness control data from the brightness timing circuit.

6. A display system according to claim 1, wherein the display is an interlaced scanning type display; the address generator also generates a field bit indicating whether the field being scanned in the display is an odd or even field; an address signal except for the field bit is applied to the graphic memory; one bit resolution control data is stored in the graphic memory for each word; the serial picture element data, the read-out resolution control data and the field bit are supplied to a resolution control circuit; the resolution control circuit outputs all the input serial picture element data when the field bit takes one of its two values, and cuts off or outputs the input serial picture element data in accordance with the resolution control data when the field bit takes the other value; and the output picture element data from the resolution control circuit is provided to the brightness modulator.

7. A display system according to claim 6, wherein the resolution control circuit includes a timing means for timing the control based on the resolution control data with the serial picture element data and a brightness timing circuit for supplying the read-out brightness control data to the brightness modulator at the same timing as the serial picture element data.

8. A display system according to claim 7, wherein each word of the graphic memory consists of eight bits, the picture element data having one bit for each picture element and consisting of at least six picture element data and the brightness control data and the resolution control data being each one-bit.

9. A display system according to claim 7, wherein data indicating the auxiliary display images are stored as the picture element data in the graphic memory; a measured signal to be displayed as a waveform is supplied from the measuring instrument to the brightness modulator; and the brightness modulator applies, as display signals, to the display the input measured signal and a signal of a level corresponding to the output picture element data from the resolution control circuit and the output brightness control data from the brightness timing circuit.

10. A display system for displaying the results of measurement by a measuring instrument and/or auxiliary images on a scanning type display (109), in which an address signal indicative of the position of scanning on the display screen of the display is generated by an address generator (104) in synchronism with the scanning; a graphic memory (106) is read out by the address signal from the address generator; the graphic memory has stored therein, for each word, picture element data of plural picture elements; the picture element data simultaneously read out of the graphic memory are converted by a parallel-serial converter (108) into serial picture element data for each plural picture elements; the serial picture element data is supplied to a brightness modulator (204); the brightness modulator applies, as a display signal, to the scanning type display (109) a signal of a level corresponding to the value of each picture element of the input picture element data; characterized in that:

the graphic memory (106) has stored therein, in each word, one-bit resolution control data;

the graphic memory is read out by the address signal from which has removed a field bit indicating whether the field being scanned in the display is an odd or even field; and

a resolution control circuit (201) is provided which is supplied with the serial picture element data from the parallel-serial converter (108), the resolution control data read out of the graphic memory (106) and the field bit separated from the address signal, and which outputs all the input serial picture element data when the field bit takes one of its two values, and sends out or cuts off the input serial picture element data in accordance with the input resolution control data when the field bit takes the other value, the output picture element data being supplied to the brightness modulator (204).

11. A display system according to claim 10, wherein the resolution control circuit includes a timing means for timing the control based on the input resolution control data with the serial picture element data.

## FIG. 1 PRIOR ART

## FIG. 2 PRIOR ART

FIG. 3

FIG. 4C DF₀ DF₁ DF₂ DF₃ DF₄ DF₅ DF₀ ---------- DF₅

FIG. 4B

FIG. 4A ⌐302

FIG. 4D ⌐303

FIG. 4E DF'₆

→ t

FIG. 5

## FIG. 6

## FIG. 7